# EUROPÄISCHE PATENTSCHRIFT

(11) **EP 0 844 691 B1**
(45) Veröffentlichungstag und Bekanntmachung des Hinweises auf die Patenterteilung: **02.04.2003**
(21) Anmeldenummer: 97113728.6
(22) Anmeldetag: 08.08.1997
(51) Int. Cl.: H01R 9/26

(54) **Schwenkbares dezentrales Eingabe-/Ausgabemodul für einen Datenbus**
Pivoted decentralised input/output module for a databus
Module pivotant décentralisé d'entrées/sorties pour bus de données

(30) Priorität: 22.11.1996 DE 19648351
(43) Veröffentlichungstag der Anmeldung: 27.05.1998
(73) Patentinhaber: Wieland Electric GmbH, 96045 Bamberg (DE)
(72) Erfinder: Kubernus, Gerhard, D-96114 Hirschaid-Sassanfahrt (DE); Schuir, Alexander, D-96047 Bamberg (DE); Strack, Holger, D-96047 Bamberg (DE)
(74) Vertreter: Tergau, Enno, Dipl.-Ing.

(56) Entgegenhaltungen:
- EP-A- 0 710 064
- DE-A- 4 402 001
- DE-A- 4 402 002
- DE-U- 29 606 007
- US-A- 5 320 552
- US-A- 5 419 715

## Beschreibung

Die vorliegende Erfindung betrifft ein Ein-/Ausgabemodul mit den Merkmalen des Oberbegriffs des Anspruchs 1. Ein derartiges Ein-/Ausgabemodul ist beispielsweise bekannt aus der EP 0 710 064. Weitere Ein-/Ausgabemodule sind der DE-A-44 02 001 sowie der DE-A-44 02 002 zu entnehmen.

Es ist insbesondere bekannt, mehrere Ein-/Ausgabemodule (I/O-Module) auf Tragschienen nebeneinander anzuordnen, um sie beispielsweise in Schaltschränken unterzubringen. Diese nebeneinander angeordneten I/O-Module werden dann mechanisch und elektrisch miteinander verkoppelt. Dabei enthält nur das erste Modul, d. h. das Basismodul oder der Buskoppler, einen Buskoppelbaustein, der die logische Verbindung zwischen dem Bus und den I/O-Modulen herstellt. Dies ist z. B. für eine Hausinstallation aus der DE-C 196 05 698 bekannt. Problematisch hierbei ist die Zugänglichkeit der einzelnen Module zu Austausch- und Servicezwecken. Insbesondere ist es stets erforderlich, die mit einem hohen Arbeitsund Montageaufwand verbundene Verdrahtung komplett zu demontieren.

Ausgehend von diesem bekannten Stand der Technik liegt der vorliegenden Erfindung die Aufgabe zugrunde, ein Ein-/Ausgabemodul für einen Datenbus konstruktiv zu vereinfachen und zu verbessern. Diese Aufgabe ist durch die Merkmalskombination des Anspruchs 1 in erfinderischer Weise gelöst.

Das erfindungsmäßige Ein-/Ausgabemodul - branchenüblich als Input/Output-Modul bezeichnet - weist nach Anspruch 1 ein auf einer Tragschiene adaptierbares Isoliergehäuse auf. Durch diese Anbringungsmöglichkeit auf Tragschienen können mehrere Isoliergehäuse nebeneinander auf einer Tragschiene angeordnet sein. Natürlich ist es auch möglich, in einem Schaltschrank mehrere Tragschienen mit Isoliergehäusen nebeneinander bzw. untereinander anzuordnen. Auf einer Außenseite des Isoliergehäuses sind Anschlußkontakte nebeneinander angeordnet. Im Isoliergehäuse ist eine Leiterplatte angeordnet, auf welche Leiterbahnen für die Datenbusleitungen und für die Stromversorgung der Eingabe- / Ausgabeelektronik aufgedruckt sind.

Der Kern der Erfindung besteht darin, daß die Leiterplatte nach Art einer Schublade in das Isoliergehäuse einschiebbar ist, wobei die an den Anschlußkontakten angeschlossene Verdrahtung bei vollständig eingeschobener Leiterplatte mit der auf der Leiterplatte angeordneten Elektronik leitend verbunden ist. Um die Leiterplatte in das auf der Tragschiene montierte Isoliergehäuse einbringen zu können, ist das Isoliergehäuse des weiteren schwenkbar an der Tragschiene gelagert. Zur Montage bzw. Demontage der Leiterplatte kann das Isoliergehäuse so einfach aus der Funktionsstellung des Moduls von der Tragschiene weg herausgeschwenkt werden und die Leiterplatte entsprechend montiert bzw. demontiert werden. Vorteilhaft in diesem Zusammenhang ist die Trennung der Leiterplatte im Isoliergehäuse einerseits von der Anbringung der Verdrahtung an den Anschlußkontakten auf einer Gehäuseoberfläche andererseits. Auf diese Weise kann nämlich die Leiterplatte leicht ausgewechselt werden, ohne die montageaufwendige Verdrahtung vorher lösen zu müssen. Dies ist insbesondere vorteilhaft zur Revisions- und Servicezwecken sowie beim Einbringen modifizierter, verbesserter Versionen der auf der Leiterplatte angeordneten Technik bzw. Elektronik, weil die Leiterplatte bei vollständiger Erhaltung der montageaufwendigen Verdrahtung einfach getauscht werden kann.

Die Ansprüche 2 und 3 betreffen bevorzugte Weiterbildungen der schwenkbaren Fixierung des Ein-/Ausgabemoduls. Das erfindungsmäßige Ein- / Ausgabemodul ist insbesondere für die Adaptierung auf handelsüblich verwendeten Hutschienen verwendbar. Zur schwenkbaren Montage auf der Hutschiene ist ein Schwenkarm mittels eines Schamiergelenks am Isoliergehäuse angelenkt. Der Schwenkarm weist zur Fixierung an der Hutschiene eine zu Form der Hutschiene komplementär ausgebildete Rastausnehmung auf. Fertigungstechnisch einfach ist es, sowohl den Schwenkarm als auch das Isoliergehäuse aus vorzugsweise demselben isolierenden Kunststoff zu spritzen.

Die Ansprüche 4 bis 7 betreffen die vorteilhafte Verwendung eines quaderförmigen Isoliergehäuses. Eine der beiden großen Oberflächen des Quaders nimmt hierbei die Anschlußkontakte auf. Die Klemmstellen für die Anschlußkontakte sind hierbei vorteilhaft in handelsüblichen Klemmleisten zusammengefaßt. Die Klemmstellen können besonders einfach als Federkraftklemmen oder Schraubklemmen ausgeführt sein. Mit Hilfe einer entsprechenden Anzahl von Klemmleisten ist es einfach möglich, Aktoren, Sensoren oder ähnliche Vorrichtungen in jeder beliebigen Anschlußtechnik, beispielsweise in Ein-, Zwei-, Drei- oder Mehrleitertechnik auszuführen. Während die mit den Klemmleisten bestückte Oberfläche die Anschlußkontaktefläche des Isoliergehäuses bildet, ist vorzugsweise im Bereich der unteren Kante der der Anschlußkontaktfläche abgewandten zweiten großen Oberfläche des Quaders das Scharniergelenk für den Schwenkarm angeordnet. Diese Anordnung des Scharniergelenks gewährleistet einen großen Schwenkhub des Gehäuses derart, daß das Gehäuse von der Tragschiene bis zu einem Winkel von 90° wegschwenkbar ist. Infolge dieses großen Schwenkhubs ist das Gehäuse nach dem Wegschwenken aus der Funktionsstellung des Moduls von der Tragschiene weg von vielen Seiten her besonders gut zugänglich. Die geschilderte Anordnung des Scharniergelenks hat zudem den Vorteil, daß das Isoliergehäuse in seiner der Funktionsstellung des Moduls entsprechenden Schwenkstellung plan am Schwenkarm und damit der Tragschiene anliegt und auf diese Weise der Platzbedarf für das Isoliergehäuse minimiert ist. Zur dauerhaften Sicherung der Funktionstüchtigkeit des Moduls ist in Anspruch 7 zusätzlich vorgeschlagen, das Isoliergehäuse in Funktionsstellung zu verrasten.

Die Ansprüche 8 bis 12 betreffen die Anpassung des Isoliergehäuses an die nach Art einer Schublade in das Isoliergehäuse einführbaren Leiterplatte. Hierfür ist vorgeschlagen, die Leiterplatte durch eine Schmalseite des Quaders hindurch in den Gehäuseinnenraum einzubringen. In vorteilharter Ausführung wird hierfür eine der kurzen, bevorzugt die dem Scharniergelenk abgewandten Quaderschmalseiten verwendet. Zur Schaffung eines als Leiterplatteneinschub geeigneten Durchbruchs ist einfach die gesamte Gehäuseschmalseite offen ausgeführt, also keine Wandung vorhanden. An den Innenseiten der zu der als Leiterplatteneinschub dienenden Schmalseite lotrecht verlaufenden Seitenwände sind Führungselemente, vorzugsweise an die Eigendicke der Leiterplatte angepaßte Führungsschienen vorgesehen. Diese Führungsschienen können eine mit der Leiterplatte zusammenwirkende mechanische Kodierung aufweisen, um zu gewährleisten, daß stets nur ein vordefinierter Leiterplattentyp in einen entsprechend vordefinierten Gehäusetyp einführbar ist.

Zum Verschließen des Gehäuses in Funktionsstellung ist an der Leiterplatte eine zur Leiterplattenebene üblicherweise senkrecht verlaufende Gehäuseseitenwand angeformt. Bei vollständig eingeschobener Leiterplatte verschließt diese Gehäuseseitenwand die als Leiterplatteneinschub wirksame Gehäuseschmalseite vollständig. In Anspruch 12 ist vorgeschlagen, die Außenseite dieser Gehäuseseitenwand mit einer Typenbezeichnung oder ähnlichem zu bedrucken. Das Bedrukken stellt natürlich nur eine von vielen Arten der Anbringung eines Schriftzugs und/oder einer Typenbezeichnung dar. Ebensogut kann auf die Gehäuseseitenwand ein Typenschild aufgeklebt oder aufgenietet sein oder ein Schildträger für ein auswechselbares Schild vorhanden sein. Da die Gehäuseseitenwand mit der Leiterplatte fest verbunden ist, eignet sich sie vorteilhaft als Informationsträger für technische Daten der Leiterplatte bzw. der auf der Leiterplatte angeordneten Elektronik.

Eine Weiterbildung der Erfindung ist in den Ansprüchen 10 und 11 geschützt, wonach an der an der Leiterplatte angeformten Gehäuseseitenwand ein seitlich verschiebbarer Schlitten beweglich angeordnet ist. Dieser Schlitten dient einerseits zur formschlüssigen Verriegelung der Leiterplatte, indem er in eine entsprechende Öffnung am Isoliergehäuse eingreift. Vorteilhaft ist diese Öffnung in einer fest am isotergehäuse fixierten Seitenwand angeordnet. Durch die Einbringung einer entsprechenden Öffnung in die Seitenwandung des benachbarten Gehäuses ist eine zusätzliche formschlüssige Sicherung der benachbarten Geäuse aneinander realisiert. Vorteilhaft ist es, einen Schlitten mit viereckiger Querschnittsform zu verwenden. Gemeinsam mit den zugeordneten Öffnungen in den Gehäuseseitenwänden bildet dieser Schlitten nämlich eine seine Bedienung erleichternde Vierflächenführung. Bei in Richtung auf das benachbarte Gehäuse verschobenem Schlitten ist die Leiterplatte einerseits gegen unbeabsichtigtes Herausziehen gesichert und andererseits ein ungewolltes Schwenken des Isoliergehäuses aus der Funktionsstellung des Moduls verhindert.

In einer in Anspruch 11 beanspruchten Weiterbildung der Erfindung sind in den Schlitten zusätzliche elektrische Verbindungskontakte eingebracht. Vorteilhaft sind diese als Kontaktstecker ausgebildet. Durch das Zusammenwirken einer komplementär hierzu ausgebildeten Kontaktbuchse im Nachbargehäuse ist es mögich, eine elektrische Verbindung zwischen zwei benachbarten Gehäusen zu schaffen. Über diese elektrische Verbindung werden die benachbarten I/O-Module einerseits miteinander und andererseits mit dem Buskoppler oder Basismodul zusammengeschaltet. Dies ist beispielsweise vorteilhaft, wenn aus Sicherheitsgründen beim Demontieren von Leiterplatten gewisse Funktionen unterbrochen sein müssen. Da die Leiterplatte nur nach dem Entriegeln des Schlittens, also dem Herausführen des Schlittens aus der Öffnung des benachbarten Gehäuses möglich ist, ist die Verbindung des im Schlitten angeordneten Kontaktsteckers mit der entsprechenden Kontaktbuchse automatisch mit unterbrochen.

Die als Kontaktstecker ausgebildeten Schlitten sowie deren komplimentär ausgebildeten Kontaktbuchsen können bei einem I/O-Modul dann entfallen, wenn dieses als "stand-alone" Buskoppler den Buskoppelbaustein bereits selbst enthält.

Anspruch 13 betrifft ein am Schwenkarm ausgebildetes, das Isoliergehäuse in Richtung auf die Leiterplatte durchgreifende Federkontaktelement. Mit Hilfe der Kontaktfeder ist es möglich, eine kontaktierende, elektrische Verbindung zwischen der Leiterplatte einerseits und an der Hutschiene angebrachten Leitern andererseits herzustellen. Die Anbringung derartiger Leiter an der Hutschiene ist beispielsweise in den oben zitierten Druckschriften zum Stand der Technik ausführlich beschrieben, worauf in diesem Zusammenhang ausdrücklich Bezug genommen wird.

Die Ansprüche 14 bis 17 betreffen die Verbindung der Anschlußkontakte an der Außenseite des Isoliergehäuses einerseits mit der im Gehäuse angeordneten Leiterplatte andererseits. Zur Kontaktierung sind vorzugsweise auf den den Klemmstellen der Verdrahtung abgewandten Seiten der Klemmleiste Pins ausgebildet. Diese Pins durchsetzen die die Anschlußkontaktflächen bildende Oberfläche des Gehäuses in entsprechenden Bohrungen und stehen von der Innenseite der Anschlußkontaktfläche in Richtung auf den Innenraum des Isoliergehäuses und damit auf die Leiterplatte vor. Auf der Leiterplatte sind wiederum zweiarmige Kontaktfedern vorgesehen. Die Arme der Kontaktfedem flankieren die Pins der Klemmleisten bei eingeschobener Leiterplatte zwischen sich. An ihren jeweiligen Freienden bilden die Federarme zwischen sich einen Spalt, durch welchen die zu den jeweiligen Kontaktfedern nicht zugeordneten Pins einfach hindurchschiebbar sind. Auf diese Weise ist es möglich, mehrere Pins hintereinander auf einer Linie anzuordnen und die Leiterplatte dennoch problemlos aus- und einschieben zu können. Die Kontaktfedern sind folglich so ausgestaltet, daß sie einfach durch die Pins, welche anderen Kontaktfedern schaltungsmäßig zugeordnet sind, hindurchschiebbar sind.

In Anspruch 17 ist berücksichtigt, daß beispielsweise der Schutzleiter bzw. die Masseleitung intern in der jeweils zugeordneten Klemmleiste gebrückt sind. Diese inteme Brückung ist bei Klemmleisten aus dem Stand der Technik hinlänglich bekannt. Die interne Brückung erfolgt beispielsweise aus sicherheitstechnischen Gründen. Es ist nämlich beispielsweise nicht zulässig, den Schutzleiter über die Leiterplatte zu führen, weil eine auf der Leiterplatte aufgedruckte Leitung zu leicht brechen kann und der Schutzleiter so funktionsuntüchtig wird, ohne daß dies während des Modulbetriebs unmittelbar bemerkt wird. In diesem Fall ist nur jeweils ein Pin für die gesamte gebrückte Klemmleiste und entsprechen eine Klemmfeder auf der Leiterplatte vorgesehen. Ein Hauptvorteil der gesamten Erfindung besteht darin, daß die der Leiterplatte zugeordnete Elektronik einerseits von der Verdrahtung andererseits vollständig entkoppelt ist.

Anspruch 18 betrifft schließlich ein weiteres, erfinderisches Detail des erfindungsmäßigen Ein- / Ausgabemoduls. Danach ist es nämlich möglich, zwei benachbarten Klemmleisten mit ihren Klemmstellen bzw. die Anschlußöffnungen bildenden Anschlußbuchsen auf Lücke zueinander anzuordnen. In den Zwischenraum zwischen zwei benachbarten Anschlußöffnungen fällt auf einer gedachten Linie dann die Anschlußöffnung der benachbarten Buchse. Jeder Klemmleiste ist nach Anspruch 18 ein durchgehender Lichtwellenleiter zugeordnet. Die am Lichtwellenleiter ausgebildeten Leuchtdioden sind entsprechend der Anordnung der Klemmen ebenfalls zueinander auf Lücke angeordnet, so daß jede Anschlußöffnung bzw. jedem Klemmeneingang eine Leuchtdiode ersichtlich zugeordnet ist.. An dem dem Ein-/Ausgabemodul zugeordneten Buskoppelbaustein ist eine Cursortaste angeordnet, mit welcher jeder Eingang bzw. Ausgang der Klemmleiste angesteuert werden kann, was durch das Aufleuchten der jeweils zugeordneten Diode für den Bediener nach außen hin sichtbar ist. Die Funktionsfähigkeit des Eingangs bzw. Ausgangs ist durch eine einfache Rot-Grün-Umschaltung der jeweiligen Diode nachprüfbar.

Mit dieser Vorgehensweise ist es beispielsweise möglich, der einen Klemmleiste die 24-Volt-Leistungsverdrahtung zuzuordnen und der anderen Klemmleiste die 5-Volt-Logikverdrahtung zuzuordnen. Auf diese Weise ist es folglich möglich, mit der Erfindung auf der Leiterplatte auch den 24-V-Leistungsteil vom 5-V-Logikteil vollständig zu entkoppeln.

Anhand der in den Zeichnungen beschriebenen Ausführungsbeispiele ist die Erfindung mit weiteren Einzelheiten und Merkmalen erläutert. Es zeigen:
- Fig. 1: eine teilweise geschnittene Seitenansicht des erfindungsmäßigen Ein- /Ausgabemoduls in seiner Funktionsstellung.,
- Fig. 2: einen Schnitt gemäß Fig. 1, jedoch in einer Schnittebene, in welcher das zwischen Schwenkarm und Leiterplatte wirksame Federkontaktelement sichtbar ist,
- Fig. 3: einen weiteren, jedoch hinsichtlich des Isoliergehäuses verstümmelten Schnitt gemäß Fig. 2 zur Demonstration der drei Stellungen des Schwenkarms gegenüber dem Isoliergehäuse in Funktionsstellung (I), in teilweise geöffnetem Zustand (II) und in vollständig geöffnetem Zustand (III),
- Fig. 4: eine Draufsicht auf die Leiterplatte,
- Fig. 5: eine Seitenansicht der in Fig. 4 dargestellten Leiterplatte gemäß dem Pfeil V in Fig. 4,
- Fig. 6: eine Seitenansicht der Leiterplatte gemäß Pfeil VI in Fig. 4.

Das Isoliergehäuse 1 des erfindungsmäßigen Ein-/Ausgabemoduls ist quaderförmig. Auf seiner die Anschlußkontaktfläche 2 bildenden Quaderoberfläche sind vier Klemmleisten 3 ausgebildet. An den Klemmleisten 3 erkennbar sind die Anschlußöffnungen 4 zur Aufnahme der Verkabelung. Die in den Zeichnungen nicht dargestellte Verkabelung besteht aus einzelnen Leitem, welche in Steckrichtung 5 in die Anschlußöffnungen 4 eingeführt sind. Die Klemmleisten 3 sind mit Federklemmen versehen, von welchen die Klemmfedern 6 erkennbar sind. Durch die Anschlußkontaktfläche 2 hindurch ragen die fahnenartig ausgeführten Pins 7 in Steckrichtung 5 hindurch. Die Pins 7 der einzelnen Klemmstellen der einzelnen Klemmleisten 4 sind mittels der Pins 7 mit der im Isoliergehäuse 1 angeordneten Leiterplatte 8 verbunden.

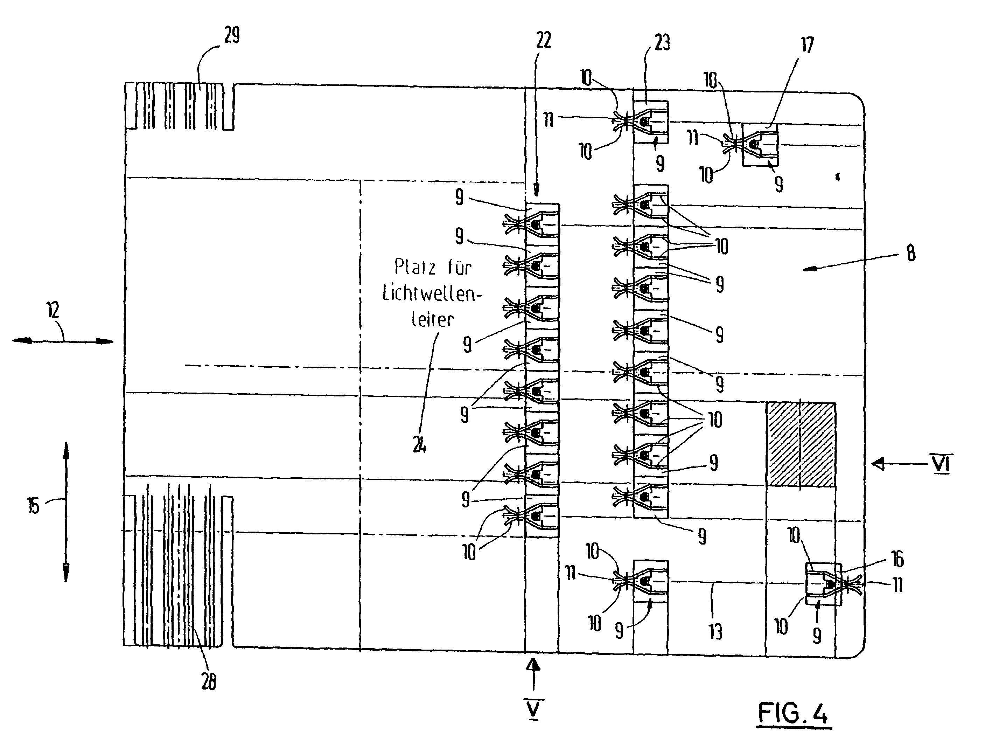

Die Leiterplatte 8 trägt hierfür einzelne Kontaktfedern 9. Die Kontaktfedern 9 weisen jeweils zwei Federarme 10 auf. Die Federarme 10 einer Kontaktfeder 9 sind jeweils spiegelbildlich konvex zueinander ausgeführt und bilden einen Schlitz 11 zwischen sich. Dieser Schlitz 11 ist so ausgestaltet, daß die Kontaktfedern 9 mit ihren konvexen Bereichen zwischen den Federarmen 10 einliegende, vorzugsweise fahnenförmige Pins 7 mit Federdruck beaufschlagen. Andererseits ist es jedoch mit Hilfe des Schlitzes 11 leicht möglich, beim Einschub der Leiterplatte 8 in der zur Steckrichtung 5 senkrecht verlaufenden Einschubrichtung 12 einzelne Pins 7 durch einzelne Klemmfedern 6 hindurchzuschieben, um die Leiterplatte 8 in ihre Montageendstellung schieben zu können. Auf diese Weise ist es möglich, mehrere Kontaktfedern 9 bzw. mehrere Pins 7 auf einer Einschubebene anzuordnen, was durch die Hilfslinie 13 in Fig. 4 angedeutet ist.

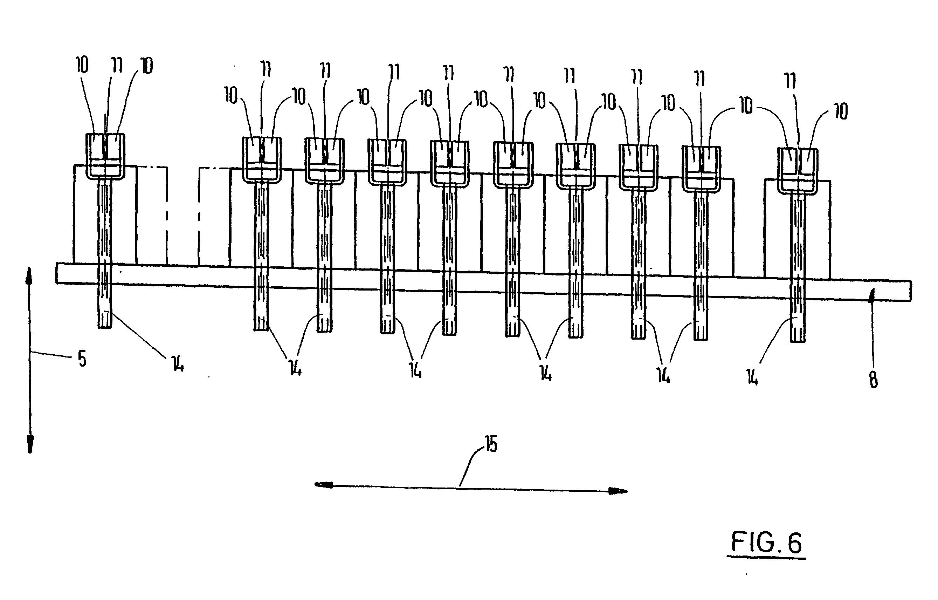

Die Kontaktfedern 9 sind mit ihren Kontaktstiften 14 in der Leiterplatte 8 fixiert. Aus Fig. 6 ist erkennbar, daß in der zur Steckrichtung 5 und zur Einschubrichtung 12 jeweils rechtwinklig verlaufenden Querrichtung 15 analog den Klemmleisten 3 auf der Leiterplatte 8 eine der Anzahl der einzelnen Klemmstellen der Klemmleisten entsprechende Anzahl von Kontaktfedern 9 nebeneinander aufgereiht ist.

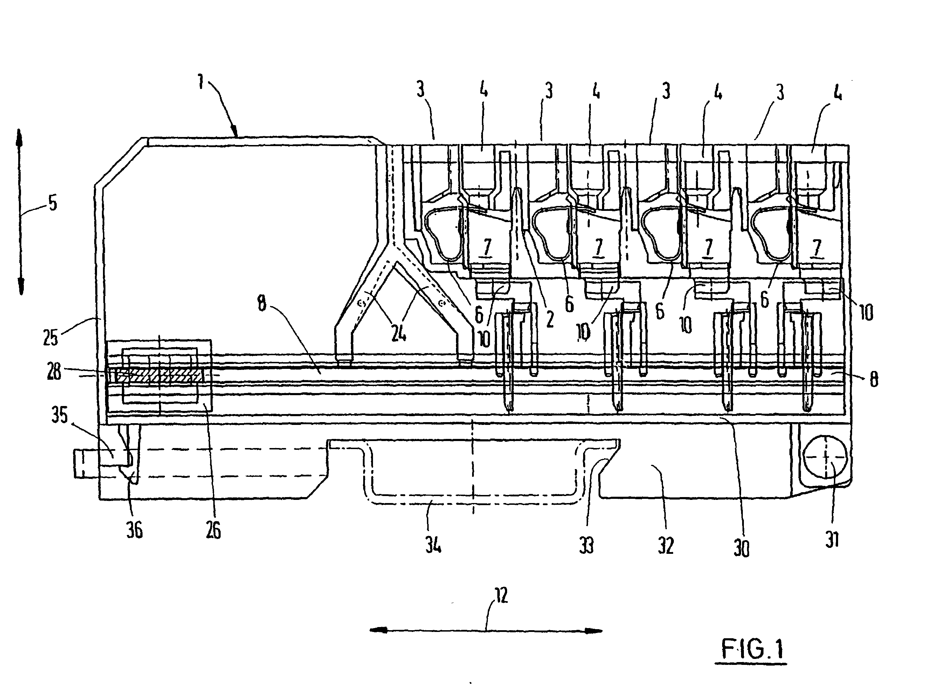

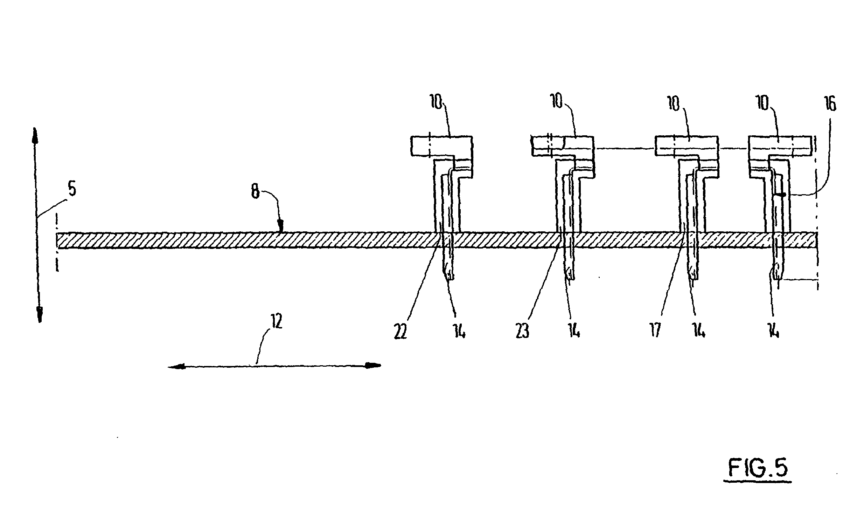

Die in Fig. 1 beiden rechten Klemmleisten 3 dienen zum Anschluß des Schutzleiters bzw. der Masse. Beide Klemmleisten 3 sind intern gebrückt, so daß nur ein Pin 7 und entsprechend eine Kontaktfeder 9 auf der Leiterplatte 8 vorgesehen ist. Dies ist in Fig. 4 und Fig. 5 erkennbar. Dort ist die dem rechten Leiterplattenrand nächstgelegene Kontaktfeder 9 der Schutzleiteranschluß 16. In Einschubrichtung 12 benachbart ist dem Schutzleiteranschluß 16 der Masseanschluß 17 (Fig. 4 / Fig. 5).

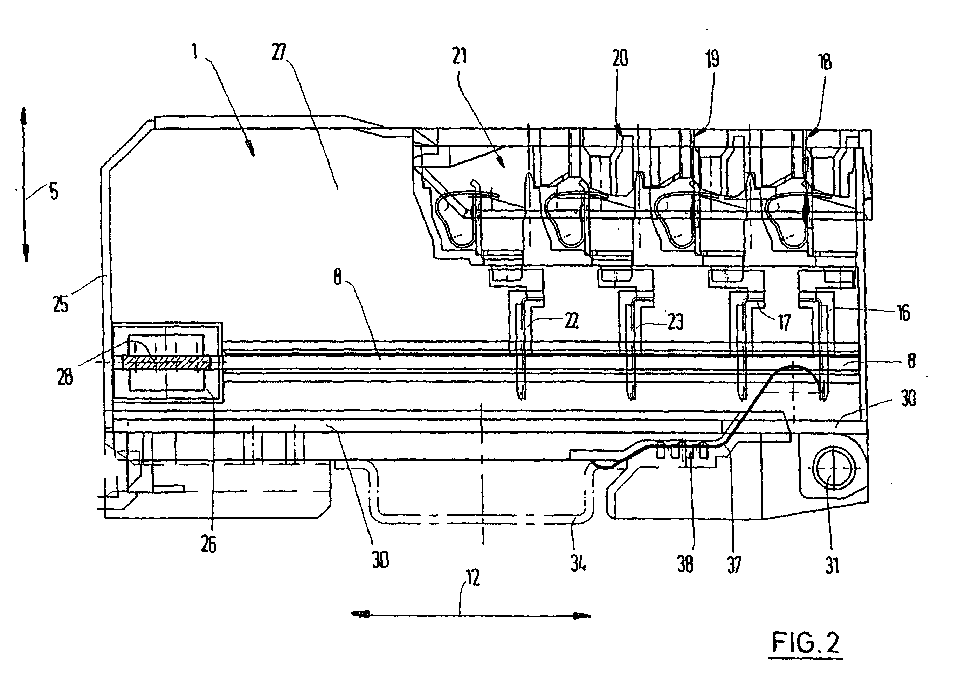

In Fig. 2 sind dementsprechend die Schutzleiterklemmleiste mit 18 und die Masseklemmleiste mit 19 gekennzeichnet. In Fig. 2 in Einschubrichtung 12 neben der Masseklemmleiste 19 angeordnet ist die Plusklemmleiste 20. In Einschubrichtung 12 neben der Plusklemmleiste 20 ist angeordnet die Signalanschlußklemmleiste 21. Der Signalanschlußklemmleiste 21 zugeordnet sind die Signalkontaktfedem 22 auf der Leiterplatte 8. Dementsprechend sind der Plusklemmleiste 20 auf der Leiterplatte 8 zugeordnet die Pluskontaktfedern 23.

In Fig. 1 weiterhin dargestellt sind die beiden Lichtwellenleiter 24. In den Zeichnungen nicht dargestellt sind die von den Lichtwellenleitem 24 versorgten Dioden zur Funktionsüberprüfung der einzelnen Anschlüsse der Signalanschlußklemmleisten 21 bzw. der den Leistungsteil bildenden Plusklemmleiste 20.

In den Fig. 1 und 2 erkennbar ist die in den Fig. 4,5 und 6 nicht dargestellte, mit der Leiterplatte 8 verbundene Gehäuseseitenwand 25. Bei vollständig in das lsoliergehäuse 1 in Einschubrichtung 12 eingeschobener Leiterplatte 8 verschließt die Gehäuseseitenwand 25 das Isoliergehäuse 1 von der Einschubseite her. In Fig. 1 angedeutet ist des weiteren der eine viereckige Querschnittsform aufweisende Schlitten 26. Der Schlitten 26 ist an der Gehäusewand 25 in Querrichtung 15 verschieblich gelagert und dient der Verriegelung des Gehäuses in der in Fig. 1 dargestellten Funktionsstellung. Der Schlitten 26 durchgreift in Querrichtung 15 in einer Öffnung die zur Gehäuseseitenwand 25 lotrecht in Einschubrichtung 12 verlaufende Gehäusewand 27. In der dem in Fig. 1 bzw. Fig. 2 dargestellten Isoliergehäuse 1 benachbarten Gehäusewand 27 des benachbarten Isoliergehäuses ist eine der Öffnung in der Gehäusewand 27 entsprechende Öffnung eingearbeitet, welche der Schlitten 26 ebenfalls durchgreift. Der Schlitten 26 verbindet mit seinen in den Figurenzeichnungen nicht dargestellten Leitelementen das Kontaktfeld 28 der in seinem Isoliergehäuse 1 angeordneten Leiterplatte 8 mit dem Anschlußkontaktfeld 29 der Leiterplatte 8 im jeweils angrenzenden Isoliergehäuse 1.

In Fig. 1 schließlich erkennbar ist an der der Anschlußkontaktfläche 2 abgewandten Rückseite 30 des Isoliergehäuses 1 das Scharniergelenks 31. Mittels des Schrniergelenks 31 ist am Isoliergehäuse 1 angelenkt der Schwenkarm 32. In den Schwenkarm 32 eingeformt ist die Rastausnehmung 33. Mit der Rastausnehmung 33 ist der Schwenkarm aufgesetzt auf die Hutschiene 34. In der in Fig. 1 dargestellten Funktionsstellung des Ein-/Ausgabemoduls ist der Schwenkarm 32 mit seiner Arretierbacke 35 von dem am Isoliergehäuse 1 angeformten Rasthaken 36 hintergriffen am Isoliergehäuse 1 verrastet. In Fig. 2 erkennbar ist das Federkontaktelement 37. Das Federkontaktelement 37 liegt in der in Fig. 1 und Fig. 2 dargestellten Funktionsstellung des Ein-/Ausgabemoduls an der Hutschiene 34 an. Aus Fig. 2 erkennbar ist die Tatsache, daß das Federkontaktelement 37 die Rückseite 30 des Isoliergehäuses 1 durchgreift und auf diese Weise einen leitenden Kontakt zwischen der Hutschiene 34 und der Leiterplatte 8 herstellt. Zeichnerisch angedeutet ist ein am Federkontaktelement 37 ausgebildeter Kontaktbereich 38 zur Realisierung weiterer elektrischer Kontakte.

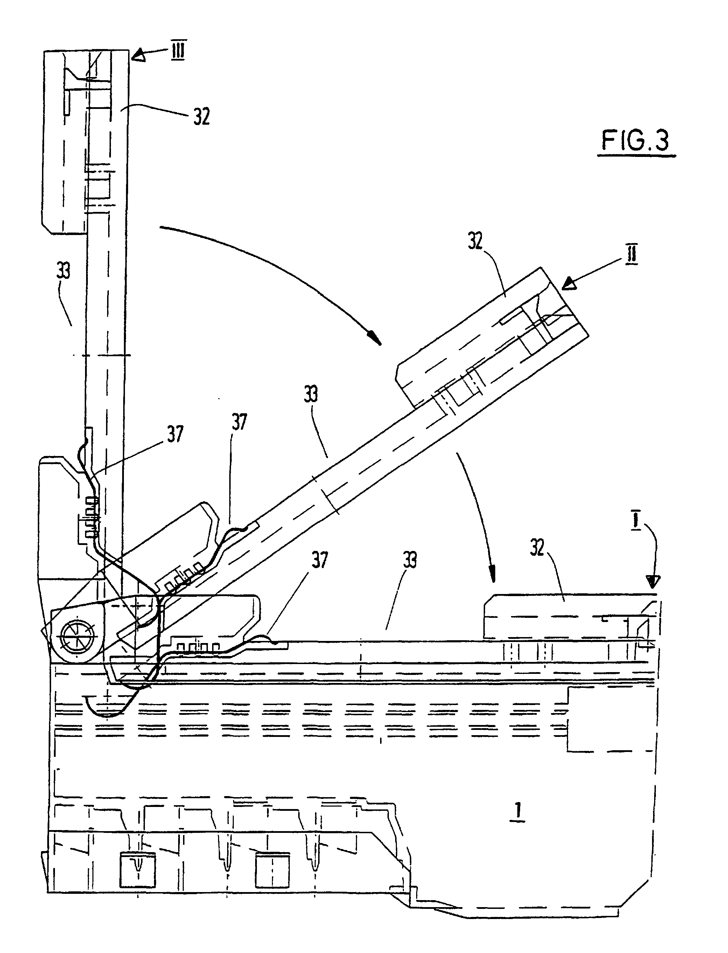

Die Wirkungsweise der Vorrichtung (Fig. 3) ist folgende:
Zum Öffnen des Isoliergehäuses 1 und zum Entfernen der Leiterplatte 8 in Einschubrichtung 12 wird zunächst der Schlitten 26 in Querrichtung 15 in seine Öffnungsstellung verfahren, so daß er das Anschlußkontaktfeld 29 der im benachbarten Isoliergehäuse 1 eingebrachten Leiterplatte 8 nicht mehr kontaktiert. Sodann wird die zwischen der Arretierbacke 35 und dem Rasthaken 36 wirksamen Verrastung entriegelt. Das Isoliergehäuse 1 ist in Schwenkrichtung 39 vom Schwenkarm 32 weggeschwenkt. Der Schwenkarm 32 bleibt mit seiner Rastausnehmung 33 mit der Hutschiene 34 weiterhin verbunden. Aus Fig. 3 schematisch erkennbar ist die Tatsache, daß in der Stellung I, welche der in Fig. 1 und Fig. 2 dargestellten Funktionsstellung des Ein-/Ausgabemoduls entspricht, der Schwenkarm 32 an der Rückseite 30 des Isoliergehäuses 1 anliegt. In Stellung II ist das Isoliergehäuse 1 vom Schwenkarm 32 um einen Betrag von 45° weggeschwenkt in Stellung III schließlich ist das Isoliergehäuse 1 vom Schwenkarm 32 um 90° weggeschwenkt. In dieser Stellung ist die Leiterplatte 8 durch Griff an die Gehäuseseitenwand 25 einfach in Einschubrichtung 12 aus dem Gehäuse 1 herausziehbar. Hierbei durchgleitet der sich auf der Hilfslinie 13 bewegende, dem Schutzletteranschluß 16 zugeordnete Pin 7 die Federame 10 der in Einschubrichtung 12 in Fig. 4 links davon liegende, am Ende der Hilfslinie 13 befindlichen Kontaktfeder 9.

## Patentansprüche

1. Ein-/Ausgabemodul für einen Datenbus
- mit einem auf einer Tragschiene (34) fixierbaren Isoliergehäuse (1),
- mit einer Leiterplatte (8), auf der eine Elektronik angeordnet und die schubladenartig in das Isoliergehäuse (1) einschiebbar ist,
- mit auf einer Oberfläche (2) des Isoliergehäuses (1) nebeneinander angeordneten Anschlußkontakten (3,4), die bei vollständig eingeschobener Leiterplatte (8) mit der Elektronik elektrisch leitend verbunden sind,
**dadurch gekennzeichnet,**
**daß** das Isoliergehäuse (1) an einem an der Tragschiene (34) fixierbaren Schwenkarm (3) schwenkbar gelagert ist.

2. Modul nach Anspruch 1,
**dadurch gekennzeichnet,**
- **daß** die Tragschiene als Hutschiene (34) ausgebildet ist und
- **daß** der Schwenkarm (32) eine zur Hutschiene (34) komplementär ausgebildete Rastausnehmung (33) aufweist zur Aneinanderreihbarkeit mehrerer auf der Hutschiene (34) aufgerasteter Module nebeneinander.

3. Modul nach einem oder mehreren der vorhergehenden Ansprüche,
**dadurch gekennzeichnet,**
- **daß** der Schwenkarm (32) aus demselben isolierenden Werkstoff besteht wie das Isoliergehäuse (1) und
- **daß** Isoliergehäuse (1) und Schwenkarm (32) mittels eines Schamiergelenks (31) miteinander verbunden sind.

4. Modul nach einem oder mehreren der vorhergehenden Ansprüche,
**dadurch gekennzeichnet,**
- **daß** das Isoliergehäuse (1) quaderförmig ist und
- **daß** die Anschlußkontakte (3,4) auf einer der beiden Quaderoberflächen (2) nebeneinander angeordnet sind.

5. Modul nach einem oder mehreren der vorhergehenden Ansprüche,
**dadurch gekennzeichnet,**
- **daß** die Anschlußkontakte als Klemmleisten (3) ausgeführt sind und
- **daß** mehrere Klemmleisten (3) unterschiedlichen Potentials auf einer Gehäusefläche (2) nebeneinander angeordnet sind.

6. Modul nach Anspruch 4 und Anspruch 5,
**dadurch gekennzeichnet,**
- **daß** das Schamiergelenk (31) auf der den Anschlußkontakten (3) abgewandten Quaderoberfläche (30) vorzugsweise im Bereich einer Gehäusekante angeordnet ist und
- **daß** der Schwenkarm (32) in Funktionsstellung des Moduls auf der den Anschlußkontakten (3) abgewandten Quaderoberfläche (30) aufliegt.

7. Modul nach einem oder mehreren der vorhergehenden Ansprüche,
**dadurch gekennzeichnet,**
**daß** das Isoliergehäuse (1) gegenüber dem Schwenkarm (32) in der Funktionsstellung des Moduls arretierbar, vorzugsweise verrastbar ist.

8. Modul nach einem oder mehreren der vorhergehenden Ansprüche,
**dadurch gekennzeichnet,**
**daß** die Leiterplatte (8) von einer Quaderschmalseite her in das Isoliergehäuse (1) einschiebbar ist.

9. Modul nach Anspruch 8,
**dadurch gekennzeichnet,**
- **daß** die als Leiterplatteneinschub wirksame Schmalseite des lsoliergehäuses (1) eine kurze Schmalseite des Quaders ist,
- **daß** das Isoliergehäuse (1) im Bereich des Leiterplatteneinschubs offen ist und
- **daß** die Gehäuseseitenwand (25) im Bereich des Leiterplatteneinschubs mit der Leiterplatte (8) verbunden, vorzugsweise an die Leiterplatte (8) angeformt ist.

10. Modul nach Anspruch 9,
**dadurch gekennzeichnet,**
- **daß** an der mit der Leiterplatte (8) verbundenen Gehäuseseitenwand (25) ein in der Seitenwandebene verschieblicher Schlitten (26) beweglich angeordnet ist und
- **daß** in beiden lotrecht zu der an der Leiterplatte (8) angeformten Gehäuseseitenwand (25) verlaufenden, festen Gehäusewänden (27) entsprechende Öffnungen ausgespart sind zur Durchführung und Aufnahme des Schlittens (26) als Verschwenksicherung zweier benachbarter Module in Funktionsstellung.

11. Modul nach Anspruch 10,
**dadurch gekennzeichnet,**
**daß** in den Schlitten (26) vorzugsweise als Kontaktstecker ausgebildete elektrische Verbindungskontakte eingebracht sind zur zusätzlich elektrisch leitenden Verbindung einzelner benachbarter Module miteinander.

12. Modul nach einem oder mehreren der vorhergehenden Ansprüche,
**dadurch gekennzeichnet,**
**daß** die Außenseite der mit der Leiterplatte (8) verbundenen Gehäuseseitenwand (25) ein mit einer Typenbezeichung oder ähnlichem bedruckbares Schriftfeld ist.

13. Modul nach einem oder mehreren der vorhergehenden Ansprüche,
**gekennzeichnet durch**
ein im Bereich der Rastausnehmung (33) am Schwenkarm (32) ausgebildetes Federkontaktelement (37), welches die in Funktionsstellung des Moduls dem Schwenkarm (32) benachbarte Gehäusefläche (30) in Richtung auf die im Isoliergehäuse (1) eingeschobene Leiterplatte (8) in einer Federöffnung durchgreift zur leitenden Kontaktierung eines an der Hutschiene (34) angeordneten Leiters einerseits und der Leiterplatte (8) andererseits.

14. Modul nach einem oder mehreren der vorhergehenden Ansprüche,
**dadurch gekennzeichnet,**
- **daß** aus den vorzugsweise als Klemmleisten (3) ausgebildeten Anschlußkontakten Pins (7) abstehen und
- **daß** in der den Anschlußkontakten (3) zugeordneten Gehäuseoberfläche (2) eine mindestens der Anzahl der Pins (7) entsprechende Anzahl von Bohrungen vorgesehen ist derart,
- **daß** bei montierten Anschlußkontakten (3) die Pins (7) das Gehäuse (1) in den Bohrungen durchsetzen und in Richtung auf die Leiterplatte (8) in den Gehäuseinnenraum hineinragen.

15. Modul nach einem oder mehreren der vorhergehenden Ansprüche,
**gekennzeichnet durch**
auf der Leiterplattenoberfläche angeordnete, zweiarmige, jeweils einen Pin (7) zwischen sich bei eingeschobener Leiterplatte (8) druckbeaufschlagende Kontaktfedem (9) zum elektrischen Anschluß der Leiterplatte (8) an die Anschtußkontakte.

16. Modul nach Anspruch 15,
**gekennzeichnet durch**
einen freien Schlitz (11) zwischen den jeweils einander gegenüberliegenden Freienden der beiden eine Kontaktfeder (9) bildenden Federarme (10) derart, daß beim Einschieben der Leiterplatte (8) der jeweiligen Kontaktfeder (9) nicht zugeordnete Pins (7) **durch** die Kontaktfeder (4) in Leiterplatteneinschubrichtung (12) hindurchschiebbar sind.

17. Modul nach einem oder mehreren der vorhergehenden Ansprüche,
**gekennzeichnet durch**
- eine interne Brückung der dem Schutzleiter und/oder dem Masseleiter zugeordneten Klemmleiste (18, 19),
- nur einen aus dieser Klemmleiste (18,19) in das Gehäuse hineinragenden Pin (7) und
- entsprechend jeweils nur eine Kontaktfeder (16,17) auf der Leiterplatte (8) zum Anschluß des Schutzleiters und/oder der Masseleitung.

18. Modul nach einem oder mehreren der vorhergehenden Ansprüche,
**dadurch gekennzeichnet,**
- **daß** mindestens zwei Klemmleisten (3) auf Lücke zueinander stehen derart, daß jeweils eine Anschlußöffnung (4) der einen Klemmleiste (3) zwischen zwei Anschlußöffnungen (4) der zweiten - vorzugsweise benachbarten - Klemmleiste (3) positioniert sind,
- **daß** jeder der Klemmleisten (3) jeweils ein durchgehender Lichtwellenleiter (24) zugeordnet ist mit Leuchtdioden, die jeweils einer vordefinierten Anschlußöffnungen (4) zugeordnet sind und
- **daß** auch die einzelnen Leuchtdioden entsprechend den zugeordneten Anschlußöffnungen (4) zueinander auf Lücke stehen.

## Revendications

1. Module d'entrée/sortie pour un bus de données
- équipé d'un boîtier isolant (1) pouvant être fixé sur un rail support (34),
- équipé d'une plaquette de circuit imprimé (8), sur laquelle est disposée une électronique et qui peut être introduite à la manière d'un tiroir dans le boîtier isolant (1),
- équipé de contacts de raccordements (3, 4) disposés juxtaposés sur une surface (2) du boîtier isolant (1), qui sont reliés d'une manière électriquement conductrice avec l'électronique lorsque la plaquette de circuit imprimé (8) est complètement introduite,
**caractérisé,**
- **en ce que** le boîtier isolant (1) est disposé à pivotement sur un bras pivotant (3) pouvant être fixé au rail support (34).

2. Module selon la revendication 1, **caractérisé**
- **en ce que** le rail support est réalisé sous la forme d'un rail à chapeau (34) et
- **en ce que** le bras pivotant (32) présente un évidement d'arrêt (33) complémentaire du rail à chapeau (34) en vue de la juxtaposition de plusieurs modules fixés sur le rail à chapeau (34).

3. Module selon une ou plusieurs des revendications précédentes, **caractérisé,**
- **en ce que** le bras pivotant (32) est en même matériau isolant que le boîtier isolant (1), et
- **en ce que** le boîtier isolant (1) et le bras pivotant (32) sont réunis au moyen d'une charnière (31).

4. Module selon une ou plusieurs des revendications précédentes, **caractérisé en ce que**,
- le boîtier isolant (1) est parallélépipédique et
- **en ce que** les contacts de raccordement (3, 4) sont juxtaposés sur une des deux surfaces du quadrilatère (2)

5. Module selon une ou plusieurs des revendications précédentes, **caractérisé,**
- **en ce que** les contacts de raccordement sont réalisés sous la forme de barrettes de connexion (3) et
- **en ce que** plusieurs barrettes de connexion (3) de potentiel différent sont juxtaposées sur une surface de boîtier (2).

6. Module selon la revendication 4 et la revendication 5, **caractérisé,**
- **en ce que** la charnière (31) est disposée sur la surface du quadrilatère (30) éloignée des contacts de raccordement (3) de préférence à proximité d'un bord du boîtier et
- **en ce que** le bras pivotant (32) repose en position de fonctionnement du module sur la surface du quadrilatère (30) éloignée des contacts de raccordement (3).

7. Module selon une ou plusieurs des revendications précédentes, **caractérisé en ce que** le boîtier isolant (1) peut être stoppé vis-à-vis du bras pivotant (32) dans la position fonctionnelle du module, de préférence peut être verrouillé.

8. Procédé selon une ou plusieurs des revendications précédentes, **caractérisé en ce que** la plaquette de circuit imprimé (8) peut être introduite depuis un petit côté du quadrilatère dans le bottier isolant (1).

9. Module selon la revendication 1, **caractérisé,**
- **en ce que** le petit côté du boîtier isolant (1) agissant en tant qu'introduction de la plaquette de circuit imprimé est un petit coté du quadrilatère,
- **en ce que** le boîtier isolant (1) est ouvert à proximité de l'introduction de la plaquette de circuit imprimé et
- **en ce que** la paroi latérale de boîtier (25) est reliée à proximité de l'introduction de la plaquette de circuit imprimé avec la plaquette de circuit imprimé (8), de préférence est formée sur la plaquette de circuit imprimé (8).

10. Module selon la revendication 9, **caractérisé**
- **en ce que** sur la paroi latérale de boîtier (25) reliée à la plaquette de circuit imprimé (8) est disposé de façon mobile un traîneau (26) déplaçable dans le plan de la paroi latérale et
- **en ce que** dans les deux parois de boîtier fixe (27), s'étendant perpendiculairement à la paroi latérale de boîtier (25) formée sur la plaquette de circuit imprimé (8), des ouvertures correspondantes sont pratiquées en vue du passage et de la réception du traîneau (26) en tant que maintien oblique de deux modules adjacents en position fonctionnelle.

11. Module selon la revendication 10, **caractérisé en ce que** dans le chariot (26) sont disposés des contacts de liaison électrique réalisés de préférence en tant que fiches de contact en vue de la liaison électriquement conductrice supplémentaire de différents modules adjacents entre eux.

12. Module selon une ou plusieurs des revendications précédentes, **caractérisé en ce que** le côté extérieur de la paroi latérale du boîtier (25) reliée à la plaquette de circuit imprimé (8) porte une désignation littérale ou autre champ d'écriture pouvant être imprimé analogue.

13. Module selon une ou plusieurs des revendications précédentes, **caractérisé par** un élément de contact élastique (37) réalisé à proximité de l'évidement d'arrêt (33) sur le bras pivotant (32), qui traverse la surface de boîtier (30) adjacente dans la position de fonctionnement du module au bras pivotant (32) en direction de la plaquette de circuit imprimé (8) introduite dans le boîtier isolant (1) dans une ouverture élastique en vue du contact d'un conducteur disposé sur le rail à chapeau (34) d'une part et de la plaquette de circuit imprimé (8) d'autre part.

14. Module selon une ou plusieurs des revendications précédentes, **caractérisé en ce que**,
- des broches de contact de raccordement (7) s'éloignent des contacts de raccordement réalisés de préférence sous la forme de barrettes de connexion (3) et
- **en ce que** dans la surface de boîtier (2) associée aux contacts de raccordement (3) est prévu un nombre d'alésages correspondant au moins au nombre des broches (7) de telle sorte que,
- dans le cas des contacts de raccordement montés (3) les broches (7) traversent le boîtier (1) dans les alésages et pénètrent dans l'espace interne du boîtier en direction de la plaquette de circuit imprimé (8).

15. Module selon une ou plusieurs des revendications précédentes, **caractérisé par** des ressorts de contact (9) à deux bras, disposés sur la surface de la plaquette de circuit imprimé, sollicitant par pression une broche (7) dans le cas de la plaquette de circuit inoprimé introduite (8) en vue du raccordement électrique de la plaquette de circuit imprimé (8) aux contacts de raccordement.

16. Module selon la revendication 15, **caractérisé par** une fente libre (11) entre les extrémités libres en vis-à-vis l'une de l'autre des deux bras élastiques (10) formant un ressort de contact (9) de telle sorte que, lors de l'introduction de la plaquette de circuit imprimé (8) des ressorts de contact respectifs (9) des broches (7) non associées peuvent être introduites par les ressorts de contact (4) dans la direction d'introduction dans la plaquette de circuit imprimé (12).

17. Module selon une ou plusieurs des revendications précédentes, **caractérisé par**
- un pontage interne de la barrette de connexion (18, 19) associée au conducteur de protection et/ou au conducteur de masse,
- seulement une broche (7) faisant saillie de cette barrette de connexion (18, 19) dans le boîtier et
- de façon correspondante respectivement seulement un ressort de contact (16, 17) se trouve sur la plaquette de circuit imprimé (8) en vue du raccordement du conducteur de protection et/ou du fil de masse.

18. Module selon une ou plusieurs des revendications précédentes, **caractérisé,**
- **en ce qu'**au moins deux barrettes de connexion (3) se trouvent en vis-à-vis l'une de l'autre sur des lacunes de telle sorts que respectivement une ouverture de raccordement (4) de la première barrette de connexion (3) est positionnée entre deux ouvertures de raccordement (4) de la seconde barrette de connexion (3) de préférence adjacente,
- **en ce qu'**à chacune des barrettes de connexion (3) est associé un conducteur d'ondes lumineuses (24) continu avec des diodes électroluminescentes, qui sont associées respectivement à une des ouvertures de raccordement (4) prédéterminées et
- **en ce qu'**également les différentes diodes électroluminescentes se trouvent sur des lacunes correspondant aux ouvertures de raccordement associées (4).

## Claims

1. Input/output module for a data bus
- having an insulating housing (1) which can be fixed on a mounting rail (34),
- having a printed circuit board (8) on which electronics are arranged and which can be pushed into the insulating housing (1) like a drawer,
- having connecting contacts (3, 4) which are arranged alongside one another on one surface (2) of the insulating housing (1) and are electrically conductively connected to the electronics when the printed circuit board (8) is inserted completely,
**characterized**
**in that** the insulating housing (1) is mounted on a pivoting arm (3) which can be fixed on the mounting rail (34), such that it can pivot.

2. Module according to Claim 1,
**characterized**
- **in that** the mounting rail is in the form of a top-hat section rail (34) and
- **in that** the pivoting arm (32) has a latching recess (33), which is configured such that it is complimentary to the top-hat section rail (34), in order to allow a number of modules, which are latched on the top-hat section rail (34), to be arranged in a row alongside one another.

3. Module according to one or more of the preceding claims,
**characterized**
- **in that** the pivoting arm (32) is composed of the same insulating material as the insulating housing (1), and
- **in that** the insulating housing (1) and the pivoting arm (32) are connected to one another by means of a hinged joint (31).

4. Module according to one or more of the preceding claims,
**characterized**
- **in that** the insulating housing (1) is cuboid, and
- **in that** the connecting contacts (3, 4) are arranged alongside one another on one of the two cuboid surfaces (2).

5. Module according to one or more of the preceding claims,
**characterized**
- **in that** the connecting contacts are in the form of terminal strips (3), and
- **in that** a number of terminal strips (3) at different potentials are arranged alongside one another on one housing surface (2).

6. Module according to Claim 4 and Claim 5,
**characterized**
- **in that** the hinged joint (31) is arranged on that cuboid surface (30) which faces away from the connecting contacts (3), preferably in the region of one housing edge, and
- **in that**, when the module is in the functional position, the pivoting arm (32) rests on that cuboid surface (30) which faces away from the connecting contacts (3).

7. Module according to one or more of the preceding claims,
**characterized**
**in that** the insulating housing (1) can be locked, and can preferably be latched, with respect to the pivoting arm (32) when the module is in the functional position.

8. Module according to one or more of the preceding claims,
**characterized**
**in that** the printed circuit board (8) can be inserted from one narrow side of the cuboid into the insulating housing (1).

9. Module according to Claim 8,
**characterized**
- **in that** the narrow side of the insulating housing (1) which acts as the printed circuit board insert is a short narrow side of the cuboid,
- **in that** the insulating housing (1) is open in the region of the printed circuit board insert, and
- **in that** the housing sidewall (25) is connected to the printed circuit board (8) in the region of the printed circuit board insert, and is preferably integrally formed on the printed circuit board (8).

10. Module according to Claim 9,
**characterized**
- **in that** a carriage (26), which can move in the sidewall plane, is arranged such that it can move on that housing sidewall (25) which is connected to the printed circuit board (8), and
- **in that** corresponding openings are cut out in both fixed housing walls (27) which run at right angles to that housing sidewall (25) which is integrally formed on the printed circuit board (8), in order to hold the carriage (26) and as a passage for the carriage (26), as protection against two adjacent modules pivoting when in the functional position.

11. Module according to Claim 10,
**characterized**
**in that** electrical connecting contacts, which are preferably in the form of contact plugs, are incorporated in the carriage (26) as an additional electrically conductive connection between individual adjacent modules.

12. Module according to one or more of the preceding claims,
**characterized**
**in that** the outside of that housing sidewall (25) which is connected to the printed circuit board (8) is an inscription area on which the type designation or the like can be printed.

13. Module according to one or more of the preceding claims,
**characterized by**
a spring contact element (37), which is formed on the pivoting arm (32) in the region of the latching recess (33) and which passes through the housing surface (30) which is adjacent to the pivoting arm (32) when the module is in the functional position, in the direction of the printed circuit board (8) which is inserted in the insulating housing (1), in a spring opening in order to make a conductive contact on the one hand with the conductor which is arranged on the top-hat section rail (34) and on the other hand with the printed circuit board (8).

14. Module according to one or more of the preceding claims,
**characterized**
- **in that** pins (7) project from the connecting contacts which are preferably in the form of terminal strips (3), and
- **in that** a number of holes corresponding at least to the number of pins (7) are provided in the housing surface (2) which is associated with the connecting contacts (3), in such a way
- that, when the connecting contacts (3) are installed, the pins (7) pass through the housing (1) in the holes, and project in the direction of the printed circuit board (8) into the housing interior.

15. Module according to one or more of the preceding claims,
**characterized by**
two-armed contact springs (9), which are arranged on the printed circuit board surface and hold a pin (7) between their arms when the printed circuit board (8) is inserted, for electrical connection of the printed circuit board (8) to the connecting contacts.

16. Module according to Claim 15,
**characterized by**
a free slot (11) between the respective mutually opposite free ends of the two spring arms (10) which form a contact spring (9), such that, when the printed circuit board (8) is inserted, pins which are not associated with the respective contact spring (9) can be pushed through the contact spring (4) in the printed circuit board insertion direction (12).

17. Module according to one or more of the preceding claims,
**characterized by**
- an internal bridge for the terminal strip (18, 19) which is associated with the protective conductor and/or the earth conductor,
- only one pin (7) which projects form this terminal strip (18, 19) into the housing, and
- in a corresponding way, in each case only one contact spring (16, 17) on the printed circuit board (8) for connection of the protective conductor and/or of the earth line.

18. Module according to one or more of the preceding claims,
**characterized**
- **in that** at least two terminal strips (3) are positioned with a gap with respect to one another, so that one connecting opening (4) of the one terminal strip (3) is in each case positioned between two connecting openings (4) of the second - preferably adjacent - terminal strip (3),
- **in that** each of the terminal strips (3) has an associated continuous optical wave guide (24) with light emitting diodes, which are each associated with predefined connecting openings (4), and
- **in that** the individual light-emitting diodes are also positioned with a gap between them, corresponding to the associated connecting openings (4).
